# EUROPEAN PATENT APPLICATION

(11) **EP 1 981 069 A2**
(43) Date of publication of application: **15.10.2008**
(21) Application number: 08003392.1
(22) Date of filing: 25.02.2008
(51) Int. Cl.: H01L 21/205

(54) **Method of producing group III-V compound semiconductor, Schottky barrier diode, light emitting diode, laser diode, and method of fabricating the diodes**

(30) Priority: 11.04.2007 JP 2007104027
(71) Applicant: Sumitomo Electric Industries, Ltd., Osaka-shi, Osaka 541-0041 (JP)
(72) Inventor: Ueno, Masaki, Itami-shi Hyogo 664-0016 (JP); Saitoh, Yu, Itami-shi Hyogo 664-0016 (JP)
(74) Representative: Grünecker, Kinkeldey, Stockmair & Schwanhäusser Anwaltssozietät

(57) **Abstract**

There are provided a method of producing a group III-V compound semiconductor, a Schottky barrier diode, a light emitting diode, a laser diode and methods of fabricating the diodes, that can achieve a reduced n type carrier density. The method of producing a group III-V compound semiconductor is a method of producing the compound semiconductor by metal organic chemical vapor deposition employing a material containing a group III element. Initially the step of preparing a seed substrate (S10) is performed. Then the step of growing a group III-V compound semiconductor on the seed substrate is performed by employing as a group III element-containing material an organic metal containing at most 0.01 ppm of silicon, at most 10 ppm of oxygen and less than 0.04 ppm of germanium (S20).

## Description

### BACKGROUND OF THE INVENTION

### Field of the Invention

The present invention relates generally to methods of producing group III-V compound semiconductors, Schottky barrier diodes, light emitting diodes, laser diodes and methods of fabricating such diodes. For example the present invention relates to methods of producing group III-V compound semiconductors, Schottky barrier diodes, light emitting diodes, laser diodes and methods of fabricating such diodes, that can achieve a reduced n type carrier density.

### Description of the Background Art

Group III-V compound semiconductor is significantly useful for Schottky barrier diodes, light emitting diodes (LEDs), laser diodes (LD) and other similar semiconductor devices. To produce such group III-V compound semiconductor, for example sublimination, hydride vapor phase epitaxy (HVPE), molecular beam epitaxy (MBE), metal organic chemical vapor deposition (MOCVD) and the like vapor phase epitaxy have conventionally been proposed.

Inter alia, MOCVD is one representative vapor phase epitaxy. It vaporizes an organic metal serving as a material containing a group III element and thermally decomposes the vaporized material at a surface of a substrate and causes the decomposed material to react with a gas containing a group V element to deposit a film. This method can control a film in thickness, composition and the like and is also excellently productive. The method is thus widely used as a technique for deposition in producing group III-V compound semiconductor.

The material containing the group III element that is used in MOCVD can for example be an organometallic compound produced in a method of producing an organometallic compound as disclosed in Japanese Patent Laying-Open No. 2006-342101. The publication discloses a method of producing an organometallic compound containing less than 0.05 ppm of organic silicon, less than 10 ppm of oxygen and less than 10 ppm of silicon carbide as impurities.

However, when the organometallic compound produced by the method disclosed in the publication is used as a group III element-containing material in MOCVD to grow an undoped group III-V compound semiconductor, the group III-V compound semiconductor has a disadvantageously high n type carrier density without n type impurity introduced. If such group III-V compound semiconductor is used to form a drift layer of a Schottky barrier diode, the drift layer has an excessively high n type carrier density and also cannot be controlled to have a carrier density lower than that high density. Furthermore, if an LED or the like is fabricated and a p type, group III-V compound semiconductor is to be grown, n type impurity concentration must be significantly reduced. More specifically, when the organometallic compound disclosed in the publication is used in MOCVD to grow a group III-V compound semiconductor, the group III-V compound semiconductor has an excessively high n type carrier density, and methods of producing a group III-V compound semiconductor having a low n type carrier density, a p type group III-V compound semiconductor and the like have room for improvement.

### SUMMARY OF THE INVENTION

The present invention therefore contemplates a method of producing a group III-V compound semiconductor, a Schottky barrier diode, a light emitting diode, a laser diode, and a method of fabricating them, that can achieve a reduced n type carrier density.

The present inventors have conducted a thorough study to find a condition allowing an undoped, group III-V compound semiconductor to be grown to have an n type carrier density reduced to a density (for example of at most 5 × 10¹⁵cm⁻³).

More specifically, the present invention provides a method of producing a group III-V compound semiconductor by metal organic chemical vapor deposition employing a material containing a group III element, including the steps of: initially preparing a seed substrate; and growing the group III-V compound semiconductor on the seed substrate by employing an organic metal as the material containing the group III element, the organic metal containing at most 0.01 ppm of silicon, at most 10 ppm of oxygen, and less than 0.04 ppm of germanium.

The present inventors have found that when MOCVD is employed to produce an undoped, group III-V compound semiconductor, an organic metal serving as a material containing a group III element can be used that contains impurities of silicon, oxygen and germanium having upper limits of at most 0.01 ppm, at most 10 ppm and less than 0.04 ppm, respectively. When the present invention is employed to grow an undoped, group III-V compound semiconductor, the group III-V compound semiconductor can have an n type carrier density reduced to a desired density (for example of at most 5 × 10¹⁵cm⁻³). Conventionally it has been difficult to control n type carrier density within a low density range. The present invention, as described above, can help to control n type carrier density in such range, and also achieve a reduced n type impurity conventionally required in producing p type, group III-V compound semiconductor.

Note that the above silicon content is a value as measured by inductively coupled plasma-atomic emission spectroscopy (ICP-AES). The above oxygen content is a value as measured by Fourier Transform-nuclear magnetic resonance (FT-NMR). The above germanium content is a value as measured by inductively coupled plasma-mass spectroscopy (ICP-MS).

In the above method of producing a group III-V compound semiconductor, preferably the organic metal is at least one type of substance selected from the group consisting of trimethylgallium, triethylgallium, trimethylaluminum, and trimethylindium.

The organic metal that is at least one of trimethylgallium, triethylgallium, trimethylaluminum, and trimethylindium is effective in producing an undoped, group III-V compound semiconductor.

In the above method of producing a group III-V compound semiconductor, preferably in the step of growing, AlₓGa_{y}In_{(1-x-y)}N is grown as the group III-V compound semiconductor, wherein 0 ≤ x ≤ 1, 0 ≤ y ≤ 1, and x + y ≤ 1.

Thus a group III-V compound semiconductor formed of AlₓGa_{y}In_{(1-x-y)}N having a reduced n type carrier density can be grown, wherein 0 ≤ x ≤ 1, 0 ≤ y ≤ 1, and x + y ≤ 1.

In the above method of producing a group III-V compound semiconductor, preferably in the step of growing, gallium nitride is grown as the group III-V compound semiconductor.

Thus a group III-V compound semiconductor formed of gallium nitride having a reduced n type carrier density can be grown.

In the above method of producing a group III-V compound semiconductor, preferably in the step of growing, another material containing an n type impurity is used together with the organic metal to grow the group III-V compound semiconductor to have an n type carrier density of at most 5 × 10¹⁶cm⁻³.

As an undoped, group III-V compound semiconductor can be produced with a reduced n type carrier density, an n type carrier density controlled to be a low density of at most 5 × 10¹⁶cm⁻³ can be achieved. A group III-V compound semiconductor having a carrier density falling within the above range can thus be produced.

In the above method of producing a group III-V compound semiconductor, preferably the n type impurity includes at least one element of silicon, germanium and oxygen.

A group III-V compound semiconductor having an n type carrier density also controlled within a low density range can thus be produced.

In the above method of producing a group III-V compound semiconductor, preferably the other material containing the n type impurity is at least one type of substance selected from the group consisting of monosilane, disilane, monomethylsilane, dimethylsilane, trimethylsilane, tetramethylsilane, triethylsilane, tetraethylsilane, monogermane, monomethylgermanium, tetramethylgermanium, tetraethylgermanium, oxygen, carbon monoxide, carbon dioxide and water.

A group III-V compound semiconductor having an n type impurity introduced therein within a range of low concentration can thus be produced.

In the above method of producing a group III-V compound semiconductor, preferably in the step of growing, another material containing a p type impurity is used together with the organic metal to grow the group III-V compound semiconductor of p type.

The organic metal is of a condition allowing a reduced n type carrier density, and the n type impurity provides a reduced compensation, which can help an introduced p type impurity to allow the compound semiconductor to exhibit p type. Effective p type carrier density can thus be improved.

In the above method of producing a group III-V compound semiconductor, preferably the other material containing the p type impurity includes at least one of biscyclopentadienylmagnesium containing at most 0.01 ppm of silicon and bisethylpentadienylmagnesium containing at most 0.01 ppm of silicon.

As the other material containing the p type impurity has a silicon content reduced to at most 0.01 ppm, the other material containing the p type impurity has an increased p type carrier density. This is effective in producing a p type, group III-V compound semiconductor.

The present invention provides a method of fabricating a Schottky barrier diode, which includes the method of producing a group III-V compound semiconductor as described above, and in the step of preparing, an n type gallium nitride substrate is prepared as a seed substrate, and in the step of growing, n type gallium nitride is grown as the group III-V compound semiconductor.

The present invention provides a Schottky barrier diode, which is fabricated by the method of fabricating a Schottky barrier diode, as described above, and includes an n type gallium nitride substrate and a layer formed of n type gallium nitride and deposited on the n type gallium nitride substrate.

The present method of fabricating a Schottky barrier diode and the present Schottky barrier diode can provide a Schottky barrier diode allowing a drift layer that is formed of the gallium nitride as aforementioned to have an n type carrier density controlled at a low density.

The present Schottky barrier diode preferably has the layer of n type gallium nitride that has a carrier density of at least 5 × 10¹⁵cm⁻³ and at most 5 × 10¹⁶cm⁻³.

When a layer of undoped, n type gallium nitride is grown, a reduced n type carrier density can be achieved, and an n type carrier density controlled within the above range can thus be achieved. A carrier density of at least 5 × 10¹⁵cm⁻³ allows the Schottky barrier diode to maintain a low on-resistance. A carrier density of at most 5 × 10¹⁶cm⁻³ allows the Schottky barrier diode to have an improved breakdown voltage.

The present invention provides a method of fabricating a light emitting diode, which is a method of fabricating a light emitting diode that includes the method of producing a group III-V compound semiconductor as described above, and in the step of preparing, an n type gallium nitride substrate is prepared as a seed substrate, and in the step of growing, p type AlₓGa_{y}In_{(1-x-y)}N is grown as the group III-V compound semiconductor, wherein 0 ≤ x ≤ 1, 0 ≤ y ≤ 1, and x + y ≤ 1.

The present light emitting diode is a light emitting diode fabricated in the method of fabricating a light emitting diode as described above, and includes an n type gallium nitride substrate and a layer formed of p type AlₓGa_{y}In_{(1-x-y)}N and deposited on the n type gallium nitride substrate, wherein 0 ≤ x ≤ 1, 0 ≤ y ≤ 1, and x + y ≤ 1.

The present method of fabricating a light emitting diode and the present light emitting diode employ an organic metal of a condition that can achieve a reduced n type carrier density to grow p type AlₓGa_{y}In_{(1-x-y)}N, wherein 0 ≤ x ≤ 1, 0 ≤ y ≤ 1, and x + y ≤ 1, and the n type impurity provides a reduced compensation, which can help an introduced and grown p type impurity to allow the compound semiconductor to exhibit p type. A light emitting diode that can improve effective p type carrier density can thus be obtained.

The present invention provides a method of fabricating a laser diode, which is a method of fabricating a laser diode including the method of producing a group III-V compound semiconductor as described above, and in the step of preparing, an n type gallium nitride substrate is prepared as a seed substrate, and in the step of growing, p type AlₓGa_{y}In_{(1-x-y)}N is grown as the group III-V compound semiconductor, wherein 0 ≤ x ≤ 1,0 ≤ y ≤ 1, and x + y ≤ 1.

The present invention provides a laser diode, which is fabricated in the method of fabricating a laser diode as described above, and includes an n type gallium nitride substrate and a layer formed of p type AlₓGa_{y}In_{(1-x-y)}N and deposited on the n type gallium nitride substrate, wherein 0 ≤ x ≤ 1, 0 ≤ y ≤ 1, and x + y ≤ 1.

The present method of fabricating a laser diode and the present laser diode employ an organic metal of a condition that can achieve a reduced n type carrier density to grow p type AlₓGa_{y}In_{(1-x-y)}N, wherein 0 ≤ x ≤ 1, 0 ≤ y ≤ 1, and x + y ≤ 1, and the n type impurity thus provides a reduced compensation, which can help an introduced p type impurity to allow the compound semiconductor to exhibit p type. A laser diode that can improve effective p type carrier density can thus be obtained.

Thus the present method of producing a group III-V compound semiconductor employs as a group III element-containing material an organic metal containing at most 0.01 ppm of silicon. The present invention can thus achieve a reduced n type carrier density.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a flowchart of a method of producing a group III-V compound semiconductor in a first embodiment of the present invention.
Fig. 2 is a schematic cross section of a Schottky barrier diode in a second embodiment of the present invention.
Fig. 3 is a schematic cross section of a light emitting diode in a third embodiment of the present invention.
Fig. 4 is a schematic cross section of a laser diode in a fourth embodiment of the present invention.
Fig. 5 represents a relationship that a Schottky barrier diode in a third example exhibits between a forward voltage and a current as represented by different carrier density.
Fig. 6 represents a relationship that the Schottky barrier diode in the third example exhibits between a reverse voltage and a current as represented by density.
Fig. 7 is a schematic cross section of a HEMT of a fourth example of the present invention.
Fig. 8 is a schematic cross section of a vertical transistor of a fifth example of the present invention.

### DESCRIPTION OF THE PREFERRED EMBODIMENTS

Hereinafter reference will be made to the drawings to describe the present invention in embodiments. In the figures, identical or like components are identically denoted and will not be described repeatedly.

### First Embodiment

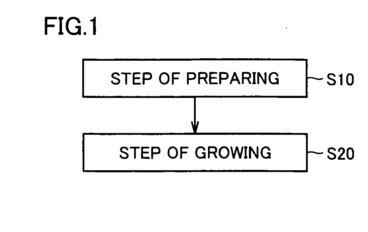

Fig. 1 is a flowchart of a method of producing a group III-V compound semiconductor in a first embodiment of the present invention. With reference to Fig. 1, the present invention in the first embodiment provides the method of producing a group III-V compound semiconductor, as will be described hereinafter. This method employs MOCVD with a group III element-containing material to produce a group III-V compound semiconductor.

In the method, as shown in Fig. 1, initially the step of preparing a seed substrate (S10) is performed. In the step of preparing (S10), for example, the seed substrate is mounted on a surface of a mount of a susceptor in an MOCVD apparatus and held by the susceptor.

While the seed substrate prepared in the step of preparing (S10) is not limited to a particular substrate, n type gallium nitride (GaN) can for example be used. Note that the seed substrate is formed preferably of the same material as the group III-V compound semiconductor grown in the step of growing (S20), as will be described later, more preferably of GaN.

Then, as shown in Fig. 1, as the group III element-containing material, an organic metal containing at most 0.01 ppm of silicon (Si), at most 10 ppm of oxygen (O), and less than 0.04 ppm of germanium (Ge) is used to perform the step of growing a group III-V compound semiconductor on the seed substrate (S20). In the step of growing (S20), MOCVD is employed to grow the group III-V compound semiconductor. In the first embodiment the step of growing (S20) grows the group III-V compound semiconductor for example as follows:
For example, with the seed substrate held on the surface of the mount of the susceptor, the susceptor is heated with a heater for example to around 1,100°C, and the heated susceptor is rotated, while gases are introduced through ports, respectively.
For example, a gas that serves as the group III element-containing material is obtained from an organic metal containing at most 0.01 ppm of silicon, at most 10 ppm of oxygen and less than 0.04 ppm of germanium. Furthermore, the organic metal is carried by gas of hydrogen (H₂), nitrogen (N₂) and/or a similar carrier gas.
Furthermore, another gas serving as a group V element-containing material is obtained from arsenic (As), phosphorus (P), ammonia (NH₃) or the like. Furthermore, still another gas is H₂ gas, N₂ gas or the like serving as a purging gas to minimize reaction of gaseous materials.

Note that the group III element-containing material is an organic metal containing at most 0.01 ppm of silicon, at most 10 ppm of oxygen and less than 0.04 ppm of germanium to achieve a reduced carrier density.

The organic metal serving as the group III element-containing material is preferably at least one type of material selected from the group consisting of trimethylgallium (TMG: Ga(CH₃)₃), triethylgallium (TEG: Ga(C₂H₅)₃), trimethylaluminum (TMA: Al(CH₃)₃) and trimethylindium (TMI: In(CH₃)₃). Trimethylgallium is particularly preferable.

The gas serving as the group III element-containing material and that serving as the group V element-containing material may be diluted with H₂ gas, N₂ gas, Ar gas or a similar carrier gas to adjust the flows of the gases serving as the materials. More specifically, by way of example, the gas serving as the group III element-containing material is trimethylgallium diluted with H₂ and the gas serving as the group V element-containing material is ammonia (NH₃) diluted with H₂.

The gases are mixed together in a space (or a reactor) internal to the MOCVD apparatus, and the gas serving as the group III element-containing material and that serving as the group V element-containing material react with each other to grow an undoped, group III-V compound semiconductor on an upper surface of the seed substrate.

In the step of growing (S20), for example GaAs, InP, AIN, GaN, InN, AlGaN, InGaN, AlInGaN or similar group III-V compound semiconductor is grown. As the group III-V compound semiconductor, AlₓGa_{y}In_{(1-x-y)}N is preferably grown, wherein 0 ≤ x ≤ 1, 0 ≤ y ≤ 1, and x + y < 1, and GaN is more preferably grown.

Furthermore, the group III-V compound semiconductor grown in the step of growing (S20) is not limited to an undoped, group III-V compound semiconductor. It may be an n type or p type, group III-V compound semiconductor.

If an n type, group III-V compound semiconductor is grown, another material containing an n type impurity is used together with the organic metal serving as the group III element-containing material. It is preferable that the n type impurity include at least one element of silicon, germanium and oxygen. Such n type impurity-containing material is preferably at least one type of substance selected from the group consisting of monosilane, disilane, monomethylsilane, dimethylsilane, trimethylsilane, tetramethylsilane, triethylsilane, tetraethylsilane, monogermane, monomethylgermanium, tetramethylgermanium, tetraethylgermanium, oxygen, carbon monoxide, carbon dioxide and water.

If a p type, group III-V compound semiconductor is grown, another material containing a p type impurity is used together with the organic metal. It is preferable that the p type impurity include magnesium. Preferably the p type impurity-containing material contains at most 0.01 ppm of silicon. More preferably the p type impurity-containing material includes at least one of biscyclopentadienylmagnesium containing at most 0.01 ppm of silicon and bisethylpentadienylmagnesium containing at most 0.01 ppm of silicon. Furthermore, preferably, the p type impurity-containing material contains at most 0.01 ppm of silicon, at most 10 ppm of oxygen and less than 0.04 ppm of germanium.

Note that in the step of growing (S20), the deposition is provided under a condition, by way of example, as follows: the gaseous materials in the reactor all have an average flow rate of 0.1 m/s to 5 m/s. The susceptor has a temperature of 600°C to 1,400°C. The reactor has an internal pressure of 10 kPa to 110 kPa. The gas serving as the group V element-containing material (e.g., ammonia) is supplied relative to that serving as the group III element-containing material at a ratio (of V to III) of 100-100,000 to 1.

The steps (S10, S20) allow a group III-V compound semiconductor to be grown on the seed substrate. If the group III-V compound semiconductor is grown as an undoped such compound semiconductor, a reduction to at most 5 × 10¹⁵cm⁻³ can be achieved. Furthermore, as it can achieve a low carrier density as an undoped such compound semiconductor, the group III-V compound semiconductor that is grown as an n type, group III-V compound semiconductor can have an n type carrier density controlled to be at most 5 × 10¹⁶cm⁻³, preferably at least 5 × 10¹⁵cm⁻³ and at most 2 × 10¹⁶cm⁻³. Furthermore, as the group III-V compound semiconductor can achieve a low carrier density as an undoped such compound semiconductor, the group III-V compound semiconductor that is grown as a p type, group III-V compound semiconductor can achieve an improved effective p type carrier density.

As has been described above, the first embodiment provides a method of producing a group III-V compound semiconductor that employs as a group III element-containing material an organic metal containing at most 0.01 ppm of silicon, at most 10 ppm of oxygen and less than 0.04 ppm of germanium to grow a group III-V compound semiconductor. Employing as the group III element-containing material the organic metal that contains impurities of silicon, oxygen and germanium having upper limits of at most 0.01 ppm, at most 10 ppm and less than 0.04 ppm, respectively, as found by the present inventors, can provide an undoped, group III-V compound semiconductor having an n type carrier density reduced to a desired density (for example of at most 5 × 10¹⁵cm⁻³). Conventionally it has been difficult to control n type carrier density within a low density range. The present method can help to control n type carrier density in such range, and also achieve a reduced n type impurity conventionally required in producing p type, group III-V compound semiconductor.

### Second Embodiment

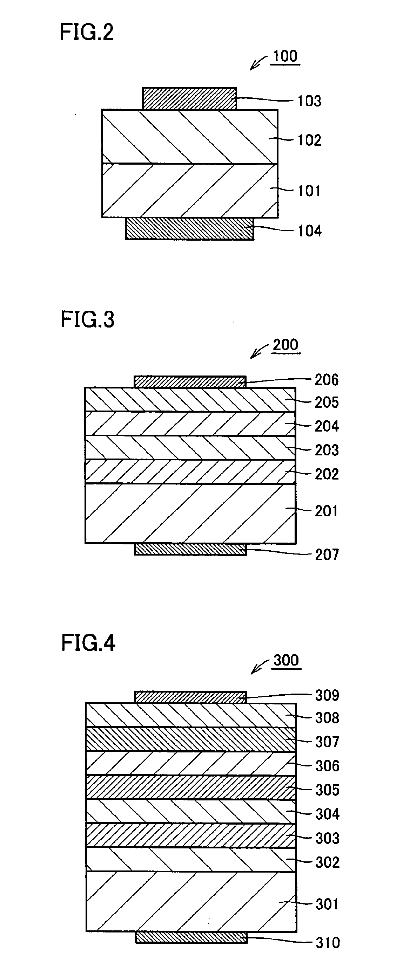

Fig. 2 is a schematic cross section of a Schottky barrier diode in a second embodiment of the present invention. With reference to Fig. 2, the present invention in the second embodiment provides the Schottky barrier diode, as will be described hereinafter. As shown in Fig. 2, the second embodiment provides a Schottky barrier diode 100 including a substrate 101, a drift layer 102, an anode electrode 103, and a cathode electrode 104.

Substrate 101 is an n type gallium nitride (GaN) substrate. Drift layer 102 is a layer formed of n type GaN and deposited on substrate 101. Drift layer 102 has a carrier density preferably of at least 5 × 10¹⁵cm⁻³ and at most 5 × 10¹⁶cm⁻³, more preferably at least 5 × 10¹⁵cm⁻³ and at most 2 × 10¹⁶cm⁻³. A carrier density of at least 5 × 10¹⁵cm⁻³ allows Schottky barrier diode 100 to maintain low on-resistance when forward voltage is applied. A carrier density of at most 5 × 10¹⁶cm⁻³ allows Schottky barrier diode 100 to have an improved breakdown voltage when reverse voltage is applied. A carrier density of at most 2 × 10¹⁶cm⁻³ allows Schottky barrier diode 100 to have a further improved breakdown voltage.

With reference to Figs. 1 and 2, the second embodiment provides a method of fabricating Schottky barrier diode 100, as will be described hereinafter. The second embodiment provides the method of fabricating Schottky barrier diode 100 that employs the method of producing a group III-V compound semiconductor as described in the first embodiment.

More specifically, initially, in the step of preparing (S10), an n type GaN substrate is prepared as a seed substrate. In the second embodiment, the seed substrate is used as substrate 101 in the Schottky barrier diode.

Then, in the step of growing (S20), a group III-V compound semiconductor of n type GaN is grown as drift layer 102 by MOCVD. In the step of growing (S20), another material containing an n type impurity is used together with the organic metal under such a condition that the compound semiconductor can have a desired n type carrier density as drift layer 102. Substrate 101 and drift layer 102 deposited on substrate 101 can thus be provided.

Then is performed the step of depositing anode electrode 103 on drift layer 102. In this step, for example gold or the like is deposited by vapor deposition to deposit the electrode.

Then is performed the step of depositing cathode electrode 104 on that surface of substrate 101 which is opposite to the surface having drift layer 102 deposited thereon. In this step, for example titanium (Ti) and aluminum (Al) or the like are deposited in layers by vapor deposition to deposit the electrode.

The steps (S10 and S20) allow Schottky barrier diode 100 to be fabricated as described in the second embodiment with reference to Fig. 2.

Thus the present invention in the second embodiment provides Schottky barrier diode 100 having as drift layer 102 an n type gallium nitride layer grown using as a group III element-containing material an organic metal containing at most 0.01 ppm of silicon, at most 10 ppm of oxygen and less than 0.04 ppm of germanium. This allows an undoped such layer to have a reduced carrier density so that an n type carrier density can be controlled within a low density range for example of at least 5 × 10¹⁵cm⁻³ and at most 5 × 10¹⁶cm⁻³. A Schottky barrier diode that can have an improved breakdown voltage and also maintain high on-resistance can thus be obtained.

### Third Embodiment

Fig. 3 is a schematic cross section of a light emitting diode in a third embodiment of the present invention. With reference to Fig. 3, the present invention in the third embodiment provides the light emitting diode, as will be described hereinafter. The third embodiment provides a light emitting diode 200 including an n type GaN substrate, and a layer formed of p type AlₓGa_{y}In_{(1-x-y)}N and deposited on the n type GaN substrate, wherein 0 ≤ x ≤ 1,0 ≤ y ≤ 1, and x + y ≤ 1.

More specifically, as shown in Fig. 3, light emitting diode 200 includes a substrate 201, an n type buffer layer 202, an active layer 203, a p type electron block layer 204, a p type contact layer 205, a p type electrode 206, and an n type electrode 207.

Substrate 201 is an n type GaN substrate. N type buffer layer 201 is deposited on substrate 201 and formed for example of n type GaN. Active layer 203 is deposited on n type buffer layer 202 and configured for example of a multiquantum well structure formed of InGaN and GaN. Note that active layer 203 may be formed of a single semiconductor material. P type electron block layer 204 is deposited on active layer 203 and formed for example of p type AlGaN. P type contact layer 205 is deposited on p type electron block layer 204 and formed for example of p type GaN. P type electrode 206 is deposited on p type contact layer 205 and formed for example of nickel and gold. N type electrode 207 is deposited on that surface of substrate 201 which is opposite to the surface having n type buffer layer 202 deposited thereon, and is formed for example of titanium and aluminum.

With reference to Figs. 1 and 3, the third embodiment provides a method of fabricating light emitting diode 200, as will be described hereinafter. This method employs the method of producing a group III-V compound semiconductor described in the first embodiment.

More specifically, initially, in the step of preparing (S10), an n type GaN substrate is prepared as a seed substrate. In the third embodiment, the seed substrate is used as substrate 201 of light emitting diode 200.

Then, in the step of growing (S20), a group III-V compound semiconductor of p type AlₓGa_{y}In_{(1-x-y)}N is grown by MOCVD, wherein 0 ≤ x ≤ 1, 0 ≤ y ≤ 1, and x + y ≤ 1. More specifically, as a group III element-containing material, an organic metal containing at most 0.01 ppm of silicon, at most 10 ppm of oxygen and less than 0.04 ppm of germanium is used to deposit on the n type GaN substrate or substrate 201 n type buffer layer 202, active layer 203, p type electron block layer 204, and p type contact layer 205 in this order. If n or p type group III-V compound semiconductor is grown, another material containing an n type impurity or another material containing a p type impurity is used together with a material for a group III element, or the organic metal, and a group V material under such a condition that a desired n or p type carrier density is achieved.

Then is performed the step of depositing p type electrode 206 on p type contact layer 205. In this step, for example nickel and gold or the like are deposited in layers by vapor deposition to deposit the electrode.

Then is performed the step of depositing n type electrode 207 on that surface of substrate 201 which is opposite to the surface having buffer layer 202 deposited thereon. In this step, for example titanium and aluminum or the like are deposited in layers by vapor deposition to deposit the electrode.

The steps (S10 and S20) allow light emitting diode 200 to be fabricated as described in the third embodiment with reference to Fig. 3.

Thus the present invention in the third embodiment provides light emitting diode 200 having a group III-V compound semiconductor of p type AlₓGa_{y}In_{(1-x-y)}N, wherein 0 ≤ x ≤ 1, 0 ≤ y ≤ 1, and x + y ≤ 1, grown by employing as a group III element-containing material an organic metal containing at most 0.01 ppm of silicon, at most 10 ppm of oxygen and less than 0.04 ppm of germanium. This allows an undoped such compound semiconductor to have a reduced carrier density, and if a p type impurity is introduced to grow p type AlₓGa_{y}In_{(1-x-y)}N, wherein 0 ≤ x ≤ 1, 0 ≤ y ≤ 1, and x + y ≤ 1, the n type impurity provides a reduced compensation, which can help the p type impurity to allow the compound semiconductor to exhibit p type. Light emitting diode 200 that can achieve an improved effective p type carrier density can thus be obtained.

### Fourth Embodiment

Fig. 4 is a schematic cross section of a laser diode in a fourth embodiment of the present invention. With reference to Fig. 4, the present invention in the fourth embodiment provides the laser diode, as will be described hereinafter. The fourth embodiment provides a laser diode 300 including an n type GaN substrate and a layer formed of p type AlₓGa_{y}In_{(1-x-y)}N and deposited on the n type GaN substrate, wherein 0 ≤ x ≤ 1, 0 ≤ y ≤ 1, and x + y ≤ 1.

More specifically, as shown in Fig. 4, laser diode 300 includes a substrate 301, an n type cladding layer 302, an undoped guide layer 303, an active layer 304, an undoped guide layer 305, a p type electron block layer 306, a p type cladding layer 307, a p type contact layer 308, a p type electrode 309, and an n type electrode 310.

Substrate 301 is an n type GaN substrate. N type cladding layer 302 is deposited on substrate 301 and formed for example of n type AlGaN. Undoped guide layer 303 is deposited on n type cladding layer 302 and formed for example of InGaN. Active layer 304 is deposited on undoped guide layer 303 and configured by a multiquantum well structure formed for example of InGaN and GaN. Note that active layer 304 may be formed of a single semiconductor material. Undoped guide layer 305 is deposited on active layer 304 and formed for example of GaN. P type electron block layer 306 is deposited on undoped guide layer 305 and formed for example of p type AlGaN. P type cladding layer 307 is deposited on p type electron block layer 306 and formed for example of p type AlGaN. P type contact layer 308 is deposited on p type cladding layer 307 and formed for example of p type GaN. P type electrode 309 is deposited on p type contact layer 308 and formed for example of nickel and gold. N type electrode 310 is deposited on that surface of substrate 301 which is opposite to the surface having n type cladding layer 302 deposited thereon, and is formed for example of titanium and aluminum.

With reference to Figs. 1 and 4, the forth embodiment provides a method of fabricating laser diode 300, as will be described hereinafter. This method employs the method of producing a group III-V compound semiconductor described in the first embodiment.

More specifically, initially, in the step of preparing (S10), an n type GaN substrate is prepared as a seed substrate. In the forth embodiment, the seed substrate is used as substrate 301 of laser diode 300.

Then, in the step of growing (S20), a group III-V compound semiconductor of p type AlₓGa_{y}In_{(1-x-y)}N is grown by MOCVD, wherein 0 ≤ x ≤ 1, 0 ≤ y ≤ 1, and x + y ≤ 1. More specifically, as a group III element-containing material, an organic metal containing at most 0.01 ppm of silicon, at most 10 ppm of oxygen and less than 0.04 ppm of germanium is used to deposit on the n type GaN substrate or substrate 301 n type cladding layer 302, undoped guide layer 303, active layer 304, undoped guide layer 305, p type electron block layer 306, p type cladding layer 307, and p type contact layer 308 in this order. If n or p type group III-V compound semiconductor is grown, another material containing an n type impurity or another material containing a p type impurity is used together with a material for a group III element, or the organic metal, and a group V material under such a condition that a desired n or p type carrier density is achieved.

Then is performed the step of depositing p type electrode 309 on p type contact layer 308. In this step, for example nickel and gold or the like are deposited in layers by vapor deposition to deposit the electrode.

Then is performed the step of depositing n type electrode 310 on that surface of substrate 301 which is opposite to the surface having n type cladding layer 302 deposited thereon. In this step, for example Ti and Al or the like are deposited in layers by vapor deposition to deposit the electrode.

The steps (S10 and S20) allow laser diode 300 to be fabricated as described in the fourth embodiment with reference to Fig. 4.

Thus the present invention in the fourth embodiment provides laser diode 300 having a group III-V compound semiconductor of p type AlₓGa_{y}In_{(1-x-y)}N, wherein 0 ≤ x ≤ 1, 0 ≤ y ≤ 1, and x + y ≤ 1, grown by employing as a group III element-containing material an organic metal containing at most 0.01 ppm of silicon, at most 10 ppm of oxygen and less than 0.04 ppm of germanium. This allows an undoped such compound semiconductor to have a reduced carrier density, and if a p type impurity is introduced to grow p type AlₓGa_{y}In_{(1-x-y)}N, wherein 0 ≤ x ≤ 1, 0 ≤ y ≤ 1, and x + y ≤ 1, the n type impurity provides a reduced compensation, which can help the p type impurity to allow the compound semiconductor to exhibit p type. This can improve effective p type carrier density, and laser diode 300 having an increased threshold current and an increased slope efficiency (a rate at which an output increases relative to a current after lasing) can thus be obtained.

### First Example

In a first example, it is confirmed how effective it is to use as a group III element-containing material of the present invention an organic metal containing at most 0.01 ppm of silicon, at most 10 ppm of oxygen and less than 0.04 ppm of germanium to grow an undoped, group III-V compound semiconductor on a seed substrate.

### First Example of the Present Invention

In a first example of the present invention the method of producing a group III-V compound semiconductor as described in the first embodiment is employed to produce an undoped, group III-V compound semiconductor. More specifically, in the step of preparing (S 10), a sapphire substrate is prepared. Then, in the step of growing (S20), the seed substrate is cleaned in an atmosphere of hydrogen at 1,050°C and 100 Torr. Then the temperature is decreased to 500°C, and at 100 Torr and with a ratio of a group V element-containing material to a group III element-containing material being a ratio of 1,600 to 1, MOCVD is employed to grow a 30 nm GaN layer as a buffer layer.

Then the temperature is increased to 1,050°C, and at 200 Torr and with a ratio of the group V element-containing material to the group III element-containing material being a ratio of 1,250 to 1, a 2 µm GaN layer is grown as a group III-V compound semiconductor of the first example of the present invention.

Note that the group III element-containing material is TMG containing at most 0.01 ppm of silicon, as measured by ICP-AES, at most 10 ppm of oxygen, as measured by FT-NMR, and germanium undetectable with a lower detection limit of 0.04 ppm, as measured by ICP-MS. The group V element-containing material is ammonia of at least 99.999% in purity. Furthermore, carrier gases of hydrogen and nitrogen each of at least 99.999995% in purity are used.

### First Comparative Example

A first comparative example provides a method of producing a group III-V compound semiconductor, that is basically similar in configuration to the method of the first example of the present invention, except that the former employs a group III element-containing material of TMG containing 0.02 ppm of silicon, as measured by ICP-AES, at most 10 ppm of oxygen, as measured by FT-NMR, and germanium undetectable with a lower detection limit of 0.04 ppm, as measured by ICP-MS.

### Method of Measurement

The group III-V compound semiconductor of the first example of the present invention and that of the first comparative example are measured for carrier density by capacitance-voltage (C-V) measurement. Furthermore, secondary ion mass spectrometry (SIMS) is employed to measure impurity in concentration. The measurement provides a result as shown below in Table 1.

**Table 1**

| | Si Content In TMG | N Carrier Density | Si Content in Semiconductor |
|---|---|---|---|
| First Example of the Present Invention | at most 0.01 ppm | at most 5 × 10¹⁵cm⁻³ | at most 1 × 10¹⁶cm⁻³ |
| First Comparative Example | 0.02 ppm | 5 × 10¹⁶cm⁻³ | 5 × 10¹⁶cm⁻³ |

### Result of Measurement

As shown in Table 1, when the group III element-containing material of the first example of the present invention, i.e., TMG containing at most 0.01 ppm of silicon, at most 10 ppm of oxygen, and less than 0.04 ppm of germanium, is used to produce a group III-V compound semiconductor, the group III-V compound semiconductor has a carrier density lower than that of the first comparative example. Furthermore, it has been confirmed that the present group III-V compound semiconductor can achieve a low carrier density of at most 5 × 10¹⁵cm⁻³ desired for undoped, group III-V compound semiconductor.

Furthermore, the group III element-containing material or the TMG and the produced group III-V compound semiconductor have their respective Si contents in a correlative relationship. It has thus been confirmed that the Si serving as an impurity in the TMG is introduced into the group III-V compound semiconductor and serves as an n type impurity.

Thus it has been confirmed from the first example that a group III element-containing material of an organic metal containing at most 0.01 ppm of silicon, at most 10 ppm of oxygen, and less than 0.04 ppm of germanium can be used to grow an undoped group III-V compound semiconductor having a reduced n type carrier density.

### Second Example

In a second example, it is confirmed how effective it is to use as a group III element-containing material of the present invention an organic metal containing at most 0.01 ppm of silicon, at most 10 ppm of oxygen and less than 0.04 ppm of germanium to grow a group III-V compound semiconductor on a seed substrate with n type carrier density controlled.

### Second Example of the Present Invention

In a second example of the present invention the method of producing a group III-V compound semiconductor as described in the first embodiment is employed to produce an n type, group III-V compound semiconductor. More specifically, this method is basically similar in configuration to that of the first example of the present invention, except for the step of growing (S20).

More specifically, in the second example of the present invention, at the step of growing (S20), initially, similarly as has been described in the first example of the present invention, MOCVD is employed to grow a buffer layer. Then, as another material containing an n type impurity, 20 ppm of monosilane gas diluted with H₂ is used together with the group III element-containing material, group V element-containing material and carrier gas as used in the first example of the present invention. A group III-V compound semiconductor having Si introduced therein as an n type impurity is thus produced.

### Second Comparative Example

A second comparative example provides a method of producing a group III-V compound semiconductor that is basically similar in configuration to that of the second example of the present invention, except that in the step of growing (S20), 20 ppm of monosilane gas diluted with H₂ is used as another material containing an n type impurity, together with the III element-containing material, i.e., TMG, group V element-containing material and carrier gas as used in the first comparative example.

### Method of Measurement

The group III-V compound semiconductor of the second example of the present invention and that of the second comparative example are measured for carrier density by C-V measurement, similarly as done in the first example.

### Result of Measurement

The group III-V compound semiconductor of the second example of the present invention has a carrier density varying in a range of at least 5 × 10¹⁵cm⁻³ and at most 5 × 10¹⁶cm⁻³ with the amount of the monosilane gas supplied. It can be seen therefrom that n type carrier density can satisfactorily be controlled by Si.

In contrast, the group III-V compound semiconductor of the second comparative example has an unchanged carrier density of 5 × 10¹⁶cm⁻³.

Thus it can be confirmed from the second example that the group III-V compound semiconductor of the second example of the present invention allows an undoped layer to be formed with a low carrier density, and thus enables intentionally introduced Si to control n type carrier density.

### Third Example

In a third example, it is confirmed how effective it is to use as a group III element-containing material of the present invention an organic metal containing at most 0.01 ppm of silicon, at most 10 ppm of oxygen and less than 0.04 ppm of germanium to fabricate a Schottky barrier diode.

### Third Example of the Present Invention

In the present invention in a third example the Schottky barrier diode shown in Fig. 2 is fabricated in accordance with the method of fabricating a Schottky barrier diode as described in the second embodiment.

More specifically, in the step of preparing (S10), an n type, 2 inch, GaN substrate is prepared. Furthermore, a c plane of the seed substrate is used as a plane at which a group III-V compound semiconductor is grown. The GaN substrate has an n type carrier density of 5 × 10¹⁸cm⁻³.

Then, in the step of growing (S20), a 7 µm thick GaN layer having Si introduced as an n type impurity is grown by MOCVD under a condition similar to that applied in the method of producing a group III-V compound semiconductor in the second example of the present invention. This GaN layer (or drift layer 102) has an n type carrier density of 1 × 10¹⁶cm⁻³.

Then as anode electrode 103 a Schottky electrode of gold is deposited on drift layer 102. Then, cathode electrode 104 is deposited. More specifically, Ti, Al, Ti and Au are deposited in layers to deposit an ohmic electrode on that surface of substrate 101 which is opposite to the surface having drift layer 102 deposited thereon.

### Third Comparative Example

A third comparative example provides a method of fabricating a Schottky barrier diode, that is basically similar in configuration to that of the third example of the present invention, except that in the step of growing (S20), a drift layer is grown under a condition similar to that applied in the method of producing a group III-V compound semiconductor in the second comparative example. The GaN layer (or drift layer 102) has an n type carrier density of 5 × 10¹⁶cm⁻³.

### Method of Measurement

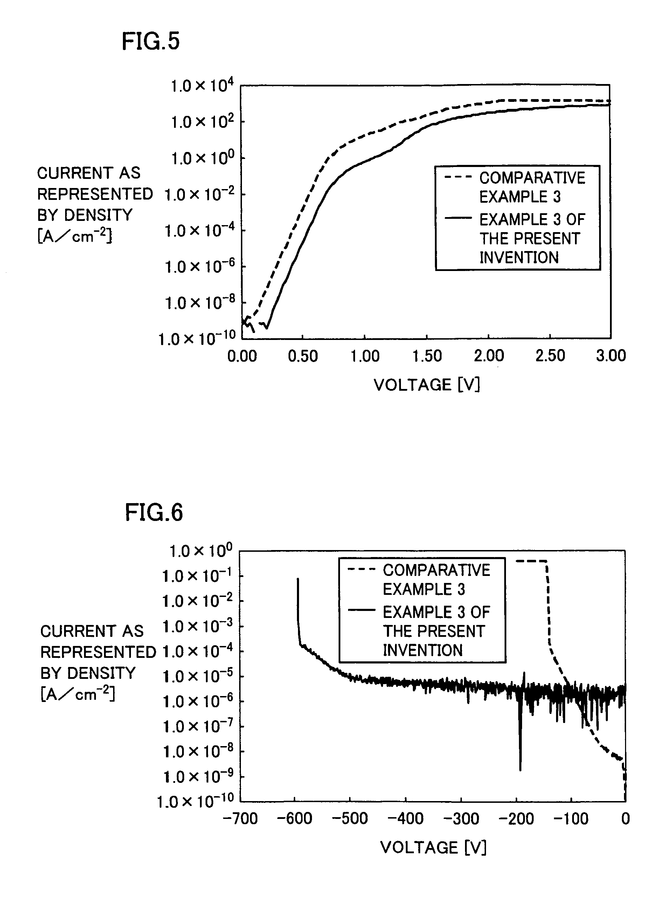

The Schottky barrier diode of the third example of the present invention and that of the third comparative example have their respective current-voltage characteristics measured with direct-current voltage applied in the forward and reverse directions. A result thereof is shown in Table 2 and Figs. 5 and 6. Fig. 5 represents a relationship that each Schottky barrier diode in the third example exhibits between a forward voltage and a current as represented by density. In Fig. 5, the vertical axis represents the current as represented by density in A/cm⁻², and the horizontal axis represents the voltage in V. Fig. 6 represents a relationship that each Schottky barrier diode in the third example exhibits between a reverse voltage and a current as represented by density. In Fig. 6, the vertical axis represents the current as represented by density in A/cm⁻², and the horizontal axis represents the voltage in V.

**Table 2**

| | Breakdown Voltage in Reverse Direction | Resistance in Forward Direction |
|---|---|---|
| Third Example of the Present Invention | 600V | 2 mΩcm² |
| Third Comparative Example | 150V | 1 mΩcm² |

### Result of Measurement

As shown in Table 2 and Figs. 5 and 6, the Schottky barrier diode of the third example of the present invention has an n type carrier density of at least 5 × 10¹⁵cm⁻³, which falls within a sufficiently low density range, and in comparison with the third comparative example, exhibits an improved breakdown voltage when reverse voltage is applied. Furthermore, when forward voltage is applied, the third example of the present invention exhibits an on-resistance of substantially the same extent as the low on-resistance of the third comparative example.

It can thus be confirmed from the third example that a Schottky barrier diode having a drift layer having a low n type carrier density of at least 5 × 10¹⁵cm⁻³ and at most 5 × 10¹⁶cm⁻³ can reduce loss and achieve high breakdown voltage.

### Fourth Example

In a forth example, it is confirmed how effective it is to use as a group III element-containing material of the present invention an organic metal containing at most 0.01 ppm of silicon, at most 10 ppm of oxygen and less than 0.04 ppm of germanium to fabricate a high electron mobility transistor (HEMT).

### Forth Example of the Present Invention

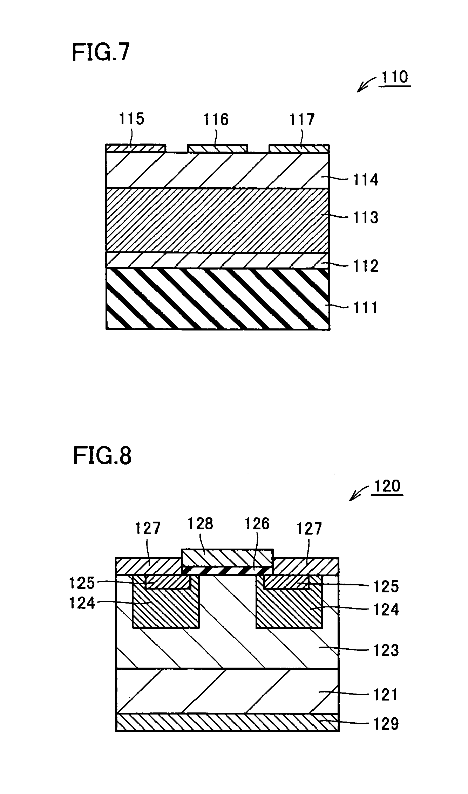

In the present invention in a forth example the HEMT shown in Fig. 7 is fabricated in accordance with the method of fabricating a Schottky barrier diode as described in the second embodiment. Fig. 7 is a schematic cross section of the HEMT of the fourth example of the present invention.

More specifically, in the step of preparing (S10), an n type, 2 inch, sapphire substrate is prepared as a substrate 111. Furthermore, a c plane of the seed substrate is used as a plane at which a group III-V compound semiconductor is grown.

Then, in the step of growing (S20), similarly as has been described in the first example of the present invention, the seed substrate is cleaned in an atmosphere of hydrogen at 1,050°C and 100 Torr. Then, similarly as has been described in the first example of the present invention, the temperature is decreased to 500°C, and at 100 Torr and with a ratio of a group V element-containing material to a group III element-containing material being a ratio of 1,600 to 1, a 30 nm thick GaN layer is grown as a buffer layer 112 by MOCVD.

Then the temperature is increased to 1,050°C, and at 200 Torr and with a ratio of the group V element-containing material to the group III element-containing material being a ratio of 1,250 to 1, a 30 nm thick, undoped GaN layer 113 is grown by MOCVD. Undoped GaN layer 113 has a carrier density unmeasurable because of high resistance, and has an Si content of 5 × 10¹⁵cm⁻³.

Then, furthermore, at 100 Torr and with a ratio of the group V element-containing material to the group III element-containing material being a ratio of 1,600 to 1, a 30 nm thick, undoped AlGaN layer 114 having an Al content at a ratio of 0.25 is grown by MOCVD. Undoped AlGaN layer 114 has an n type carrier density of at most 1 × 10¹⁶cm⁻³.

Buffer layer 112, undoped GaN layer 113, and undoped AlGaN layer 114 are grown using a group III element-containing material, a group V element-containing material and carrier gas similar to those used in the first example of the present invention.

Then Ti, Al, Ti and Au are deposited in layers to deposit a source electrode 115 and a drain electrode 117 on undoped AIGaN layer 114. Then, Au and Ni are deposited in layers to deposit a gate electrode 116 on undoped AlGaN layer 114. By the above process the present invention in the fourth example provides a HEMT 110.

### Fourth Comparative Example

A fourth comparative example provides a method of fabricating a HEMT that is basically similar in configuration to the method of the fourth example of the present invention, except that the step of growing (S20) is performed with the group III element-containing material (i.e., TMG containing 0.02 ppm of silicon), group V element-containing material and carrier gas as used in the method of producing a group III-V compound semiconductor described in the first comparative example.

Note that the HEMT of the fourth comparative example has undoped GaN layer 113 having a carrier density unmeasurable because of high resistance, and an Si content of 5 × 10¹⁶cm⁻³, and undoped AlGaN layer 114 having an n type carrier density of 1 × 10¹⁶cm⁻³.

### Method of Measurement

The HEMT of the fourth example of the present invention and that of the fourth comparative example have their respective current-voltage characteristics measured with voltage applied, similarly as has been done in the third example, to measure buffer layer 112 for breakdown voltage in the reverse direction and for resistance in the forward direction. A result thereof is shown in Table 3:

**Table 3**

| | Breakdown Voltage in Reverse Direction | Resistance in Forward Direction |
|---|---|---|
| Fourth Example of the Present Invention | 900V | 1 mΩcm² |
| Fourth Comparative Example | 250V | 3 mΩcm² |

### Result of Measurement

As shown in Table 3, the HEMT of the fourth example of the present invention has undoped GaN layer 113 having a low Si content, and accordingly, has buffer layer 112 having a higher breakdown voltage, and a lower resistance in the forward direction than that in the fourth comparative example. Note that for the HEMTs of the fourth example of the present invention and the fourth comparative example have lattice defect or other impurity introduced therein to compensate for n type carrier density to provide undoped GaN layer 113 with a significantly low carrier density. The fourth example of the present invention employs highly pure TMG. This allows an undoped GaN layer 113 to have a reduced Si content, and accordingly, electron mobility can be raised and resistance in forward direction can be reduced.

It can thus be confirmed from the fourth example that an undoped GaN layer can have a reduced carrier density, and a HEMT that has a buffer layer having an enhanced breakdown voltage and achieving reduced resistance in the forward direction can be fabricated.

### Fifth Example

In a fifth example, it is confirmed how effective it is to use as a group III element-containing material of the present invention an organic metal containing at most 0.01 ppm of silicon, at most 10 ppm of oxygen and less than 0.04 ppm of germanium to fabricate a vertical transistor.

### Fifth Example of the Present Invention

In the present invention in a fifth example the vertical transistor shown in Fig. 8 is fabricated in accordance with the method of fabricating a Schottky barrier diode as described in the second embodiment. Fig. 8 is a schematic cross section of the vertical transistor of the fifth example of the present invention.

More specifically, in the step of preparing (S10), an n type, 2 inch, GaN substrate 121 is prepared. Furthermore, a c plane of the seed substrate is used as a plane at which a group III-V compound semiconductor is grown.

Then, in the step of growing (S20), initially, 20 ppm of monosilane gas diluted with H₂ is used as another material containing an n type impurity, together with the III element-containing material, group V element-containing material and carrier gas as used in the first example of the present invention, to deposit a drift layer 123 having Si introduced therein as an n type impurity. Drift layer 123 has an n type carrier density of 1 × 10¹⁶cm⁻³.

Then photolithography is employed to form a resist pattern and thereafter ion injection is employed to introduce Mg as an electrically conductive impurity into drift layer 123 at a predetermined region at a well region 124 and Si at a source region 125 to provide well region 124 and source region 125. Then is performed the step of depositing a film of SiO₂ to serve as an insulation film 126. Then Au and Ni are deposited on the film in layers to deposit a gate electrode 128 on the film. On the Au and Ni deposited in layers a resist pattern is formed by photolithography. With this resist pattern used as a mask, the Au and Ni deposited in layers and the film are partially etched away to form gate electrode 128 and insulation film 126. Then, Ti, Al, Ti and Au are deposited in layers to deposit a source electrode 127 on source region 125. Then Ti, Al, Ti and Au are deposited in layers to deposit a drain electrode 129 on that surface of substrate 121 which is opposite to the surface having buffer layer 122 deposited thereon. By the above process the present invention in the fifth example provides a vertical transistor 120.

### Fifth Comparative Example

A fifth comparative example provides a method of fabricating a vertical transistor that is basically similar in configuration to the method of the fifth example of the present invention, except that the step of growing (S20) is performed with the group III element-containing material (i.e., TMG containing 0.02 ppm of the silicon used in the method of producing a group III-V compound semiconductor), group V element-containing material and carrier gas as used in the first comparative example.

The vertical transistor of the fifth comparative example has drift layer 123 having a carrier density of 5 × 10¹⁶cm⁻³.

### Method of Measurement

The vertical transistor of the fifth example of the present invention and that of the fifth comparative example have their respective current-voltage characteristics measured with reverse voltage applied, similarly as has been done in the third example, to measure breakdown voltage. A result thereof is shown in Table 4:

**Table 4**

| | Breakdown Voltage in Reverse Direction |
|---|---|
| Fifth Example of the Present Invention | 1,200 V |
| Fifth Comparative Example | 40 V |

### Result of Measurement

As shown in Table 4, the vertical transistor in the fifth example of the present invention has undoped GaN layer 113 having a low carrier density and accordingly has a higher breakdown voltage than that of the fifth comparative example.

It can thus be confirmed from the fifth example that drift layer 123 can have a reduced carrier density, and a vertical transistor having an increased breakdown voltage can be fabricated.

### Sixth Example

In a sixth example, it is confirmed how effective it is to use as a group III element-containing material of the present invention an organic metal containing at most 0.01 ppm of silicon, at most 10 ppm of oxygen and less than 0.04 ppm of germanium to fabricate an LED.

### Sixth Example of the Present Invention

In the present invention in a sixth example the light emitting diode shown in Fig. 3 is fabricated in accordance with the method of fabricating a light emitting diode as described in the third embodiment.

More specifically, in the step of preparing (S 10), an n type, 2 inch, GaN substrate is prepared. Furthermore, a c plane of the seed substrate is used as a plane at which a group III-V compound semiconductor is grown.

Then the step of growing (S20) is performed at 1,150°C and 750 Torr with a ratio of a group V element-containing material to a group III element-containing material being a ratio of 1,100 to 1 to grow a 2 µm GaN layer as n type buffer layer 202 by MOCVD. The group III and V element-containing materials are similar to those used in the first example of the present invention. Carrier gases similar to those of the first example of the present invention, i.e., hydrogen and nitrogen, are used. Another material containing an n type impurity is monomethylsilane. N type buffer layer 202 has an n type carrier density of 3 × 10¹⁸cm⁻³.

Then active layer 203 is deposited. More specifically, at 780°C and 750 Torr and with a ratio of a group V element-containing material to a group III element-containing material being a ratio of 16,000 to 1, In_{0.14}Ga_{0.86}N of 3 nm and GaN of 15 nm are each deposited in six layers by MOCVD to provide a multiquantum well structure. The group III and V element-containing materials are similar to those used in the first example of the present invention. In is obtained from trimethylindium containing at most 0.01 ppm of silicon. A carrier gas of nitrogen is used.

Then p type electron block layer 204 is deposited. More specifically, at 1,050°C and 750 Torr and with a ratio of a group V element-containing material to a group III element-containing material being a ratio of 7,200 to 1, p type Al_{0.18}Ga_{0.82}N of 20 nm in thickness is grown by MOCVD. The group III and V element-containing materials are similar to those used in the first example of the present invention. Al is obtained from trimethylaluminum containing at most 0.01 ppm of silicon. Another material containing a p type impurity is biscyclopentadienylmagnesium. Carrier gases of nitrogen and hydrogen are used. P type electron block layer 204 has a p type carrier density of 7 × 10¹⁷cm⁻³.

Then p type contact layer 205 is deposited. More specifically, at 1,100°C and 750 Torr and with a ratio of a group V element-containing material to a group III element-containing material being a ratio of 1,600 to 1, p type GaN of 50 nm in thickness is grown by MOCVD. The group III and V element-containing materials are similar to those used in the first example of the present invention. Another material containing a p type impurity is biscyclopentadienylmagnesium. Carrier gases of nitrogen and hydrogen are used. P type contact layer 205 has a p type carrier density of 1 × 10¹⁸cm⁻³.

Then a heat treatment is performed and Ti and A1 are deposited in layers to deposit n type electrode 207 on that surface of substrate 201 which is opposite to the surface having n type buffer layer 202 deposited thereon. Then Ni and Au are deposited in layers to deposit p type electrode 206 on p type contact layer 205. A blue light emitting diode 200 of the sixth example of the present invention as shown in Fig. 3 is thus fabricated.

### Sixth Comparative Example

A sixth comparative example provides a method of fabricating a light emitting diode that is basically similar in configuration to the method of the sixth example of the present invention, except that the step of growing (S20) is performed with the group III element-containing material (i.e., TMG containing 0.02 ppm of the silicon used in the method of producing a group III-V compound semiconductor), group V element-containing material and carrier gas as used in the first comparative example.

Note that the sixth comparative example provides a p type electron block layer having a p type carrier density of 3 × 10¹⁷cm⁻³ and p type contact layer 205 having a p type carrier density of 7 × 10¹⁷cm⁻³.

### Method of Measurement

A current is passed through the p and n type electrodes of each of the light emitting diodes of the sixth example of the present invention and the sixth comparative example, respectively, to evaluate their optical outputs.

### Result of Evaluation

The light emitting diodes of the sixth example of the present invention and the sixth comparative example, respectively, emit light at 460 nm. At the time, the LED of the sixth example of the present invention provides an optical output higher by 10% than that of the sixth comparative example.

It can thus be confirmed from the sixth example that a p type, group III-V compound semiconductor having a reduced Si content and hence an improved p type carrier density can be obtained, and a light emitting diode emitting light more efficiently can thus be fabricated.

### Seventh Example

In a seventh example, it is confirmed how effective it is to use as a group III element-containing material of the present invention an organic metal containing at most 0.01 ppm of silicon to fabricate a laser diode.

### Seventh Example of the Present Invention

In the present invention in a seventh example the laser diode shown in Fig. 4 is fabricated in accordance with the method of fabricating a laser diode as described in the fourth embodiment.

More specifically, in the step of preparing (S10), an n type, 2 inch, GaN substrate is prepared. Furthermore, a c plane of the seed substrate is used as a plane at which a group III-V compound semiconductor is grown.

Then the step of growing (S20) is performed at 1,150°C and 760 Torr with a ratio of a group V element-containing material to a group III element-containing material being a ratio of 5,100 to 1 to grow a 2.3 µm thick AlGaN layer as n type cladding layer 302 by MOCVD. The group III and V element-containing materials are similar to those used in the first example of the present invention. Al is obtained from trimethylaluminum containing at most 0.01 ppm of silicon. Carrier gases of nitrogen and hydrogen are used. Another material containing an n type impurity is monomethylsilane. N type cladding layer 302 has an n type carrier density of 2 × 10¹⁸cm⁻³.

Then undoped guide layer 303 is deposited. More specifically, at 800°C and 760 Torr with a ratio of a group V element-containing material to a group III element-containing material being a ratio of 22,000 to 1, In_{0.02}Ga_{0.98}N of 50 nm in thickness is grown by MOCVD. The group III and V element-containing materials are similar to those used in the first example of the present invention. In is obtained from trimethylindium containing at most 0.01 ppm of silicon. A carrier gas of nitrogen is used. Undoped guide layer 303 has an n type carrier density of 1 × 10¹⁶cm⁻³.

Then active layer 304 is deposited. More specifically, at 800°C and 760 Torr and with a ratio of a group V element-containing material to a group III element-containing material being a ratio of 13,000 to 1, In_{0.08}Ga_{0.92}N of 3 nm and In_{0.01}Ga_{0.99}N of 15 nm are each deposited in three layers by MOCVD to provide a multiquantum well structure. The group III and V element-containing materials are similar to those used in the first example of the present invention. In is obtained from trimethylindium containing at most 0.01 ppm of silicon. A carrier gas of nitrogen is used.

Then undoped guide layer 305 is deposited. More specifically, at 1,100°C and 760 Torr with a ratio of a group V element-containing material to a group III element-containing material being a ratio of 2,300 to 1, GaN of 0.1 µm in thickness is grown by MOCVD. The group III and V element-containing materials are similar to those used in the first example of the present invention. Carrier gases of hydrogen and nitrogen are used. Undoped guide layer 305 has an n type carrier density of 1 × 10¹⁶cm⁻³.

Then p type electron block layer 306 is deposited. More specifically, at 1,100°C and 760 Torr and with a ratio of a group V element-containing material to a group III element-containing material being a ratio of 10,000 to 1, p type Al_{0.18}Ga_{0.82}N of 20 nm in thickness is grown by MOCVD. The group III and V element-containing materials are similar to those used in the first example of the present invention. Al is obtained from trimethylaluminum containing at most 0.01 ppm of silicon. Another material containing a p type impurity is biscyclopentadienylmagnesium. Carrier gases of nitrogen and hydrogen are used. P type electron block layer 306 has a p type carrier density of 5 × 10¹⁷cm⁻³.

Then p type cladding layer 307 is deposited. More specifically, at 1,100°C and 760 Torr and with a ratio of a group V element-containing material to a group III element-containing material being a ratio of 10,000 to 1, p type Al_{0.07}Ga_{0.93}N of 0.4 µm in thickness is grown by MOCVD. The group III and V element-containing materials are similar to those used in the first example of the present invention. Al is obtained from trimethylaluminum containing at most 0.01 ppm of silicon. Another material containing a p type impurity is biscyclopentadienylmagnesium. Carrier gases of nitrogen and hydrogen are used. P type cladding layer 307 has a p type carrier density of 7 × 10¹⁷cm⁻³.

Then p type contact layer 308 is deposited. More specifically, at 1,100°C and 760 Torr and with a ratio of a group V element-containing material to a group III element-containing material being a ratio of 3,300 to 1, p type GaN of 50 nm in thickness is grown by MOCVD. The group III and V element-containing materials are TMG similar to that used in the first example of the present invention. Another material containing a p type impurity is biscyclopentadienylmagnesium. Carrier gases of nitrogen and hydrogen are used. P type contact layer 308 has a p type carrier density of 1 × 10¹⁸cm⁻³.

Then a heat treatment is performed and that surface of substrate 301 which is opposite to the surface having n type cladding layer 302 deposited thereon is polished to be reduced in thickness. Furthermore, Ti and Al are deposited in layers to deposit n type electrode 310 on that surface of substrate 301 which is opposite to the surface having n type cladding layer 302 deposited thereon. Then Ni and Au are deposited in layers to deposit p type electrode 309 on p type contact layer 308. P type electrode 309 is processed to be a stripe having a width of 10 µm. Thereafter a bar having a cavity length of 800 µm is formed by cleavage. A blue-violet laser diode 300 of the seventh example of the present invention shown in Fig. 4 is thus fabricated.

### Seventh Comparative Example

A seventh comparative example provides a method of fabricating a laser diode that is basically similar in configuration to the method of the seventh example of the present invention, except that the step of growing (S20) is performed with the group III element-containing material (i.e., TMG containing 0.02 ppm of the silicon used in the method of producing a group III-V compound semiconductor), group V element-containing material and carrier gas as used in the first comparative example.

In the seventh example an undoped guide layer deposited on an active layer has an n type carrier density of 5 × 10¹⁶cm⁻³. A p type electron block layer has a p type carrier density of 3 × 10¹⁷cm⁻³. P type cladding layer 307 has a p type carrier density of 5 × 10¹⁷cm⁻³. P type contact layer 205 has a p type carrier density of 5 × 10¹⁷cm⁻³.

### Method of Measurement

A current is passed through the p and n type electrodes of each of the laser diodes of the seventh example of the present invention and the seventh comparative example, respectively, to evaluate their optical outputs.

### Result of Evaluation

The laser diode of the seventh example of the present invention provides a threshold current lower by 10% than that of the seventh comparative example, and a rate at which an output increases relative to a current after lasing, i.e., a slope efficiency, higher by 10% than that of the seventh comparative example.

It can thus be confirmed from the seventh example that a p type, group III-V compound semiconductor having a reduced Si content and hence an improved p type carrier density can be obtained, and a laser diode emitting light more efficiently can thus be fabricated.

Although the present invention has been described and illustrated in detail, it is clearly understood that the same is by way of illustration and example only and is not to be taken by way of limitation, the scope of the present invention being interpreted by the terms of the appended claims.

## Claims

1. A method of producing a group III-V compound semiconductor by metal organic chemical vapor deposition employing a material containing a group III element, comprising the steps of:
preparing a seed substrate (101, 201, 301) (S 10); and
growing said group III-V compound semiconductor (102, 202-205, 302-308) on said seed substrate (101, 201, 301) by employing an organic metal as said material containing said group III element, said organic metal containing at most 0.01 ppm of silicon, at most 10 ppm of oxygen, and less than 0.04 ppm of germanium (S20).

2. The method of producing a group III-V compound semiconductor according to claim 1, wherein said organic metal is at least one type of substance selected from the group consisting of trimethylgallium, triethylgallium, trimethylaluminum, and trimethylindium.

3. The method of producing a group III-V compound semiconductor according to claim 1, wherein in the step of growing (S20), AlₓGa_{y}In_{(1-x-y)}N is grown as said group III-V compound semiconductor, wherein 0 ≤ x ≤ 1, 0 ≤ y ≤ 1, and x + y ≤ 1.

4. The method of producing a group III-V compound semiconductor according to claim 1, wherein in the step of growing (S20), gallium nitride is grown as said group III-V compound semiconductor.

5. The method of producing a group III-V compound semiconductor according to claim 1, wherein in the step of growing (S20), another material containing an n type impurity is used together with said organic metal to grow said group III-V compound semiconductor to have an n type carrier density of at most 5 × 10¹⁶cm⁻³.

6. The method of producing a group III-V compound semiconductor according to claim 5, wherein said n type impurity includes at least one element of silicon, germanium and oxygen.

7. The method of producing a group III-V compound semiconductor according to claim 5, wherein said other material containing said n type impurity is at least one type of substance selected from the group consisting of monosilane, disilane, monomethylsilane, dimethylsilane, trimethylsilane, tetramethylsilane, triethylsilane, tetraethylsilane, monogermane, monomethylgermanium, tetramethylgermanium, tetraethylgermanium, oxygen, carbon monoxide, carbon dioxide and water.

8. A method of fabricating a Schottky barrier diode, comprising the method of producing a group III-V compound semiconductor as defined in claim 5, wherein:
in the step of preparing (S10), an n type gallium nitride substrate (101) is prepared as a seed substrate; and
in the step of growing (S20), n type gallium nitride (102) is grown as said group III-V compound semiconductor.

9. A Schottky barrier diode (100) fabricated by the method of fabricating a Schottky barrier diode as defined in claim 8, comprising:
said n type gallium nitride substrate (101); and
a layer (102) formed of n type gallium nitride and deposited on said n type gallium nitride substrate.

10. The Schottky barrier diode (100) according to claim 9, wherein said layer (102) formed of n type gallium nitride has a carrier density of at least 5 × 10¹⁵cm⁻³ and at most 5 × 10¹⁶cm⁻³.

11. The method of producing a group III-V compound semiconductor according to claim 1, wherein in the step of growing (S20), another material containing a p type impurity is used together with said organic metal to grow said group III-V compound semiconductor of p type.

12. The method of producing a group III-V compound semiconductor according to claim 11, wherein said other material containing said p type impurity includes at least one of biscyclopentadienylmagnesium containing at most 0.01 ppm of silicon and bisethylpentadienylmagnesium containing at most 0.01 ppm of silicon.

13. A method of fabricating a light emitting diode, comprising the method of producing a group III-V compound semiconductor as defined in claim 11, wherein:
in the step of preparing (S10), an n type gallium nitride substrate (201) is prepared as a seed substrate; and
in the step of growing (S20), p type AlₓGa_{y}In_{(1-x-y)}N (204, 205) is grown as said group III-V compound semiconductor, wherein 0 ≤ x ≤ 1, 0 ≤ y ≤ 1, and x + y ≤ 1.

14. A light emitting diode (200) fabricated by the method of fabricating a light emitting diode as defined in claim 13, comprising:
said n type gallium nitride substrate (201); and
a layer (204, 205) formed of p type AlₓGa_{y}In_{(1-x-y)}N and deposited on said n type gallium nitride substrate (201), wherein 0 ≤ x ≤ 1, 0 ≤ y ≤ 1, and x + y ≤ 1.

15. A method of fabricating a laser diode, comprising the method of producing a group III-V compound semiconductor as defined in claim 1, wherein:
in the step of preparing (S10), an n type gallium nitride substrate (301) is prepared as a seed substrate; and
in the step of growing (S20), another material containing a p type impurity is used together with said organic metal to grow p type AlₓGa_{y}In_{(1-x-y)}N (306-308) as said group III-V compound semiconductor of p type, wherein 0 ≤ x ≤ 1, 0 ≤ y ≤ 1, and x + y ≤ 1.

16. A laser diode (300) fabricated by the method of fabricating a laser diode as defined in claim 15, comprising:
said n type gallium nitride substrate (301); and
a layer (306-308) formed of p type AlₓGa_{y}In_{(1-x-y)}N and deposited on said n type gallium nitride substrate (301), wherein 0 ≤ x ≤ 1, 0 ≤ y ≤ 1, and x + y ≤ 1.
